# EUROPÄISCHE PATENTSCHRIFT

(11) **EP 3 527 996 B1**
(45) Veröffentlichungstag und Bekanntmachung des Hinweises auf die Patenterteilung: **29.03.2023**
(21) Anmeldenummer: 18157336.1
(22) Anmeldetag: 19.02.2018
(51) Int. Cl.: G01R 19/25, G06F 3/05

(54) **MESSANORDNUNG UND VERFAHREN ZUM MESSEN ELEKTRISCHER SIGNALE**
MEASURING SYSTEM AND METHOD FOR MEASURING ELECTRICAL SIGNALS
DISPOSITIF DE MESURE ET PROCÉDÉ DE MESURE DE SIGNAUX ÉLECTRIQUES

(43) Veröffentlichungstag der Anmeldung: 21.08.2019
(73) Patentinhaber: Siemens Aktiengesellschaft, 80333 München (DE)
(72) Erfinder: Mieske, Frank, 13053 Berlin (DE); Herrmann, Hans-Joachim, 91459 Markt Erlbach (DE); Loerke, Matthias, 16348 Basdorf (DE)
(74) Vertreter: Siemens Patent Attorneys

(56) Entgegenhaltungen:
- EP-A2- 1 786 103
- WO-A1-2015/110150
- DE-C1- 10 203 683

## Beschreibung

Die Erfindung betrifft eine Messanordnung mit zumindest zwei Messeingängen zum Erfassen von Signalen elektrischer Wechselgrößen, einer den Messeingängen nachgeordneten Abtasteinrichtung, mit der eine Abtastung der Signale unter Bildung digitaler Abtastwerte vorgenommen wird, und einer Taktnachführeinrichtung, die eine Anpassung eines von der Abtastvorrichtung für die Abtastung verwendeten Abtasttaktes hinsichtlich der Frequenz des abzutastenden Signals vornimmt, wobei die Abtasteinrichtung dazu eingerichtet ist, zumindest zwei der Signale mit jeweils einem eigenen Abtasttakt abzutasten, wobei die Taktnachführeinrichtung dazu eingerichtet ist, gleichzeitig für jedes dieser zumindest zwei Signale eine Anpassung des Abtasttaktes hinsichtlich der Frequenz des abzutastenden Signals vorzunehmen.

Die Erfindung betrifft auch ein Verfahren zum Messen elektrischer Signale mit einer solchen Messanordnung.

Eine solche Messanordnung ist z.B. aus der EP 1 786 103 A2 bekannt.

Aus der deutschen Patentschrift DE 102 03 683 C1 ist außerdem eine Messanordnung bekannt, mit der zur korrekten Abtastung der elektrischen Signale, beispielsweise elektrischer Signale eines Wechselstroms oder einer Wechselspannung, eine Nachführung des zum Abtasten der Signale verwendeten Abtasttaktes durchgeführt wird. Dafür wird die Frequenz des abzutastenden Signals bestimmt und in Abhängigkeit der Frequenz mit einer Steueranordnung eine Anpassung des Abtasttaktes vorgenommen. Der Abtasttakt wird einer Abtasteinrichtung zugeführt, die zur Abtastung des elektrischen Signals entsprechend des Abtasttaktes eingerichtet ist.

Eine Messung elektrischer Signal mit Nachführung des Abtasttaktes wird beispielsweise in Geräten eingesetzt, die zum Beobachten, Überwachen und/oder Schützen von Anlagen oder Prozessen, beispielsweise eines elektrischen Energieversorgungsnetzes, dienen. Um mit diesen Geräten eine hohe Messgenauigkeit zu erreichen, ist üblicherweise eine Abtasttaktnachführung realisiert, die über einen weiten Frequenzbereich des abzutastenden Signals arbeitet. Dabei wird die Abtasttaktnachführung zentral für das Gerät durchgeführt und auf alle Messeingänge gleichermaßen angewendet. Durch die Nachführung des Abtasttaktes kann erreicht werden, dass pro Schwingungsdauer des Signals immer dieselbe Anzahl von Abtastwerten gebildet wird.

Die zentrale Abtasttaktnachführung ist immer dann ausreichend, wenn die Signale an den Messeingängen übereinstimmende Frequenzen aufweisen. Anwendungsabhängig kann es jedoch zu Zuständen kommen, bei denen die Messstellen, an denen die Signale erfasst werden, galvanisch voneinander getrennt sind und somit unterschiedliche Frequenzen aufweisen können. Beispielsweise gibt es in Energieversorgungsnetzen Anlagen- bzw. Netzzustände, bei denen manche Messstellen voneinander temporär galvanisch getrennt sind (z.B. durch geöffnete Leistungsschalter). Dadurch sind unterschiedliche Frequenzen der Anlagenteile möglich.

Je nachdem, welches Signal zur Nachführung des Abtasttaktes verwendet wird, ergibt sich die im Gerät nachgeführte Abtastfrequenz derart, dass einige Messeingänge mit einem korrekten Abtasttakt und andere Messeingänge mit einem falschen Abtasttakt betrieben werden. Bei nicht korrekter Nachführung des Abtasttakts kommt es zu Messfehlern, die zum Fehlverhalten des Gerätes (z.B. bei Schutzgeräten für Energieversorgungsnetze zu ungewollten Schutzauslösungen, Schutzversagern, oder falschem Triggern von Recordern) führen können.

Die genannte DE 102 03 683 C1 schlägt hinsichtlich der Erfassung mehrerer Signale mit der Messanordnung vor, die oben beschriebene Vorgehensweise für jedes Signal gesondert durchzuführen, indem die Signale über einen Umschalter an die Steueranordnung zur Abtasttaktnachführung angelegt werden.

Ausgehend davon stellt sich der Fachmann die Aufgabe, Signale elektrischer Wechselgrößen auch dann effizient und zuverlässig erfassen zu können, wenn sie unterschiedliche Frequenzen aufweisen.

Die Aufgabe wird durch eine Messanordnung der eingangs genannten Art gelöst, bei der, die Messanordnung Teil eines Gerätes zum Beobachten, Überwachen und/oder Schützen eines elektrischen Energieversorgungsnetzes ist und die Messeingänge in verschiedene Nachführgruppen aufgeteilt sind, wobei jeweils Messeingänge solcher Signale, deren Frequenz aufgrund der Gegebenheiten des Energieversorgungsnetzes übereinstimmen, in derselben Nachführgruppe zusammengefasst sind; und die Taktnachführeinrichtung dazu eingerichtet ist, für jede Nachführgruppe eine Anpassung des Abtasttaktes vorzunehmen.

Gemäß der Erfindung können somit mehrere Signale mit unterschiedlichen Frequenzen gleichzeitig mit einem korrekt nachgeführten Abtasttakt abgetastet werden. Dazu ist die Taktnachführeinrichtung dazu ausgelegt, für jedes Signal eine jeweils passende Abtasttaktnachführung durchzuführen. Dies hat den Vorteil, dass auch bei Signalen mit deutlich voneinander abweichenden Frequenzen jedes Signal korrekt abgetastet wird.

Gemäß der erfindungsgemäßen Messanordnung ist vorgesehen, dass die Messanordnung Teil eines Gerätes zum Beobachten, Überwachen und/oder Schützen eines elektrischen Energieversorgungsnetzes ist.

Insbesondere solche Geräte werden nämlich zunehmend auch zur Erfassung mehrerer Signale eingesetzt, die an unterschiedlichen Messstellen im Energieversorgungsnetz erfasst werden. Dabei müssen die Signale nicht zwingend dieselbe Frequenz aufweisen, da beispielsweise zwischen den Messstellen eine galvanische Trennung (z.B. ein temporär geöffneter Schalter) vorliegt. Somit ist es von großer Wichtigkeit, Messungenauigkeiten, die auf eine nicht korrekte Nachführung des Abtasttaktes zurückgehen, zu vermeiden. Fehler bei der Messung elektrischer Größen in Energieversorgungsnetzen können nämlich zu ungewollten Abschaltungen von Teilen des Netzes oder zu Unterfunktionen des Schutzes führen, so dass das Energieversorgungsnetz nicht mehr sicher und zuverlässig betrieben werden kann.

Erfindungsgemäß ist vorgesehen, dass die Messeingänge in verschiedene Nachführgruppen aufgeteilt sind, wobei jeweils Messeingänge solcher Signale, deren Frequenz aufgrund der Gegebenheiten des Energieversorgungsnetzes übereinstimmen, in derselben Nachführgruppe zusammengefasst sind, und die Taktnachführeinrichtung dazu eingerichtet ist, für jede Nachführgruppe eine Anpassung des Abtasttaktes vorzunehmen.

Auf diese Weise können vorteilhaft bestimmte Messeingänge zu Gruppen zusammengefasst werden, so dass eine Taktnachführung nicht für jeden Messeingang separat durchgeführt werden muss.

Konkret kann vorgesehen sein, dass solche Messeingänge unterschiedlichen Nachführgruppen zugeordnet werden, die Signalen zugeordnet sind, die an galvanisch voneinander abtrennbaren Messstellen des Energieversorgungsnetzes erfasst werden.

Signale, die an galvanisch miteinander verbundenen Messstellen erfasst werden, weisen nämlich üblicherweise übereinstimmende Frequenzen auf. Sofern zwischen solchen Messstellen keine Schalteinrichtung liegt, die eine temporäre Trennstelle erzeugen kann, können die Messeingänge solcher Signale zu einer Gruppe zusammengefasst werden.

In diesem Zusammenhang kann weiter vorgesehen sein, dass die Nachführgruppen durch benutzerseitige Einstellung der Anordnung vorgebbar sind.

Dann kann die Einstellung beispielsweise im Rahmen einer Geräteparametrierung vorgenommen werden. Der Benutzer analysiert hierzu die zugehörigen Netzpläne und stellt die Nachführgruppen in geeigneter Weise ein.

Alternativ kann auch vorgesehen sein, dass die Nachführgruppen von der Messanordnung automatisch anhand der Topologie des Energieversorgungsnetzes und/oder des Zustands von Schalteinrichtungen des Energieversorgungsnetzes gebildet werden.

Dies ermöglicht eine flexible Gruppenbildung, die sich dynamisch an jeweilige Netzzustände anpassen kann. Durch automatische Analyse eines in maschinenlesbarer Form vorliegenden Netzplanes kann die Topologie derart erkannt werden, dass solche Messeingänge zu Nachführgruppen zusammengefasst werden, deren Signale nicht durch eine Trennstelle galvanisch voreinander abtrennbar sind. Außerdem kann eine dynamische Anpassung an temporär geöffnete Schalteinrichtungen durchgeführt werden, so dass bei geöffneter Schalteinrichtung die dann galvanisch getrennten Signale in unterschiedlichen Nachführgruppen behandelt werden. Nach dem Schließen der Schalteinrichtung kann dann eine Behandlung in derselben Nachführgruppe stattfinden.

Besonders effizient kann die Abtasttaktnachführung ausgestaltet werden, wenn die Taktnachführeinrichtung dazu eingerichtet ist, die Frequenz jeweils eines Signals jeder Nachführgruppe zu bestimmen und anhand der bestimmten Frequenz die Anpassung des Abtasttaktes für alle zu der jeweiligen Nachführgruppe gehörenden Messeingänge vorzunehmen.

Hierdurch kann der Aufwand für die Frequenzmessung auf ein Signal pro Nachführgruppe reduziert werden.

Gemäß einer weiteren vorteilhaften Ausführungsform ist vorgesehen, dass die Messanordnung eine Steuereinrichtung umfasst, die mindestens zwei Beobachtungs-, Schutz- und/oder Überwachungsfunktionen ausführt, und jeder Beobachtungs-, Schutz- und/oder Überwachungsfunktion ausschließlich solche Abtastwerte zugeführt werden, die durch Abtastung von Signalen an Messeingängen gewonnen worden sind, die derselben Nachführgruppe zugeordnet sind.

Hierdurch kann erreicht werden, dass nur solche Signale von einer einzelnen Beobachtungs-, Schutz- und/oder Überwachungsfunktion ausgewertet werden, deren Frequenzen übereinstimmen. Die Vermischung von Signalen, die mit unterschiedlichen Abtasttakten abgetastet worden sind, könnte nämlich zu Fehlverhalten der jeweiligen Funktion führen.

Gemäß einer weiteren vorteilhaften Ausführungsform kann zudem vorgesehen sein, dass das Gerät ein lokales Schutzgerät oder eine zentrale Datenverarbeitungsanlage ist.

Lokale Schutzgeräte werden in räumlicher Nähe der jeweiligen Messstellen eingesetzt und werten die empfangenen Signale dezentral aus. Bei Feststellung eines Fehlerzustands bezüglich des Energieversorgungsnetzes werden durch das jeweilige Schutzgerät Gegenmaßnahmen, wie z.B. das Öffnen einer Schalteinrichtung und/oder das Erzeugen eines Alarmsignals, vorgenommen. Eine zentrale Datenverarbeitungseinrichtung kann beispielsweise eine zentrale Schutzanlage sein, die in einer Leitstelle des Energieversorgungsnetzes angeordnet ist und der die Signale in analoger oder digitaler Form (z.B. über einen sogenannten Prozessbus) zugeführt werden. Die zentrale Schutzanlage führt dann eine Analyse des Netzzustands durch und sendet ggf. einen Schaltbefehl an eine oder mehrere Schalteinrichtungen. Als zentrale Datenverarbeitungseinrichtung kann auch ein Cloud-Computersystem angesehen werden, das aus einer oder mehreren Recheneinrichtungen besteht und die Schutzfunktion als Service anbietet.

Die oben genannte Aufgabe wird auch durch ein Verfahren zum Messen elektrischer Signale gelöst, wobei mit zumindest zwei Messeingängen einer Messanordnung Signale elektrischer Wechselgrößen erfasst werden; mit einer den Messeingängen nachgeordneten Abtasteinrichtung der Messanordnung eine Abtastung der Signale unter Bildung digitaler Abtastwerte vorgenommen wird; und mit einer Taktnachführeinrichtung der Messanordnung eine Anpassung eines von der Abtasteinrichtung für die Abtastung verwendeten Abtasttaktes hinsichtlich der Frequenz des abzutastenden Signals vorgenommen wird; wobei mit der Abtasteinrichtung zumindest zwei der Signale mit jeweils einem eigenen Abtasttakt abgetastet werden, indem die Taktnachführeinrichtung gleichzeitig für jedes dieser zumindest zwei Signale eine Anpassung des Abtasttaktes hinsichtlich der Frequenz des abzutastenden Signals vornimmt.

Erfindungsgemäß ist vorgesehen, dass die Messanordnung Teil eines Gerätes zum Beobachten, Überwachen und/oder Schützen eines elektrischen Energieversorgungsnetzes ist, und die Messeingänge in verschiedene Nachführgruppen aufgeteilt sind, wobei jeweils Messeingänge solcher Signale, deren Frequenz aufgrund der Gegebenheiten des Energieversorgungsnetzes übereinstimmen, in derselben Nachführgruppe zusammengefasst sind; und die Taktnachführeinrichtung für jede Nachführgruppe eine Anpassung des Abtasttaktes vornimmt.

Hinsichtlich des erfindungsgemäßen Verfahrens gelten alle zu der erfindungsgemäßen Messanordnung voranstehend und nachfolgend gemachten Ausführungen und umgekehrt in entsprechender Weise, insbesondere kann das erfindungsgemäße Verfahren bei jeder beliebigen Ausführungsform oder einer Kombination beliebiger Ausführungsformen der Messanordnung eingesetzt werden. Auch hinsichtlich der Vorteile des erfindungsgemäßen Verfahrens wird auf die zu der erfindungsgemäßen Messanordnung beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung der erfindungsgemäßen Messanordnung und des erfindungsgemäßen Verfahrens in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: ein Gerät mit einer Messanordnung mit Abtasttaktnachführung gemäß dem Stand der Technik;
- Figur 2: ein Gerät mit einer erfindungsgemäßen Messanordnung mit Abtasttaktnachführung;
- Figur 3: ein Ausführungsbeispiel eines elektrischen Energieversorgungsnetzes mit einem Gerät mit einer Messanordnung;
- Figur 4: das elektrische Energieversorgungsnetz gemäß Figur 3 in einem beispielhaften ersten Schaltzustand; und
- Figur 5: das elektrische Energieversorgungsnetz gemäß Figur 3 in einem beispielhaften zweiten Schaltzustand.

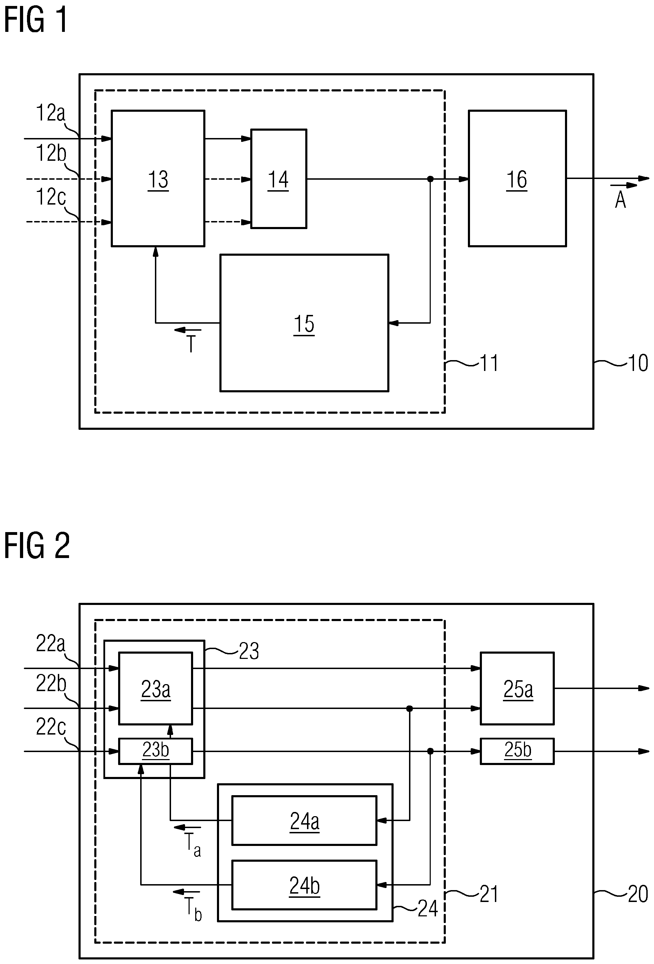

Figur 1 zeigt ein Gerät 10 mit einer Messanordnung 11 gemäß dem Stand der Technik. Die Messanordnung 11 weist einen Messeingang 12a auf. Optional können weitere Messeingänge 12b und 12c vorgesehen sein. Dem Messeingang 12a (und den optionalen Messeingängen 12b und 12c) ist eine Abtasteinrichtung 13 nachgeordnet. Der Abtasteinrichtung 13 ist ausgangsseitig über einen optionalen Umschalter 14 eine Taktnachführeinrichtung 15 nachgeordnet. Ein Taktausgang der Taktnachführeinrichtung 15 ist mit einem Takteingang der Abtasteinrichtung 13 verbunden. Der Messanordnung 11 ist außerdem eine Beobachtungs-, Schutz- und/oder Überwachungsfunktion 16 des Gerätes 10 nachgeordnet.

Die Messanordnung 11 wird wie nachfolgend beschrieben betrieben. Mit der Abtasteinrichtung 13 wird das am Messeingang 12a anliegende Signal einer elektrischen Wechselgröße in üblicher Weise abgetastet. Dabei wird zur Abtastung ein Abtasttakt verwendet, der einem am Takteingang der Abtasteinrichtung anliegenden Taktsignal T entspricht oder daraus abgeleitet ist. Da das abzutastende Signal hinsichtlich seiner Frequenz Schwankungen unterworfen sein kann, wird der verwendete Abtasttakt bezüglich der Frequenz des Signals angepasst, so dass die Anzahl der Abtastwerte pro Periodendauer des Signals konstant ist. Dazu wird mit der Taktnachführeinrichtung 15 die Frequenz des Signals in einer üblichen Weise bestimmt und daraus das Taktsignal T abgeleitet. Dieses wird der Abtasteinrichtung 13 zur Anpassung des zur Abtastung zu verwendenden Abtasttaktes zugeführt.

Die konkrete Funktionsweise der Anpassung des Abtasttaktes kann beispielsweise derjenigen entsprechen, die in der eingangs genannten Patentschrift DE 102 03 683 C1 erläutert worden ist.

Das abgetastete Signal wird außerdem auch der Beobachtungs-, Schutz- und/oder Überwachungsfunktion des Gerätes 10 zugeführt, die eine Auswertung des Signals durchführt und ggf. ein Ausgangssignal A abgibt, das von dem Ergebnis der Auswertung abgeleitet ist. Beispielsweise kann es sich bei dem Gerät 10 um ein Schutzgerät zum Schützen und Überwachen eines elektrischen Energieversorgungsnetzes handeln. In diesem Fall kann es sich bei der Funktion 16 um eine Schutzfunktion, z.B. eine Distanzschutzfunktion oder eine Überstromschutzfunktion handeln, die als Ausgangssignal A ein Fehlersignal abgibt, sofern ein Fehler in dem Energieversorgungsnetz festgestellt wird.

Sofern der Abtasteinrichtung 13 neben dem Eingangssignal 12a weitere Eingangssignale 12b und 12c zugeführt werden, kann das jeweils auszuwertende Signal über den Umschalter 14 ausgewählt werden. Die Nachführung des Abtasttaktes wird jeweils an die Frequenz des durch den Umschalter 14 ausgewählten Signals angepasst.

Mit der aus dem Stand der Technik bekannten Messanordnung 11 kann zu einem Zeitpunkt jeweils nur ein Signal ausgewertet werden.

Um mehrere Signale, die jeweils unterschiedliche Frequenzen haben können, gleichzeitig auswerten zu können, wird eine Messanordnung gemäß Figur 2 vorgeschlagen. Figur 2 zeigt ein Gerät 20 mit einer Messanordnung 21. Der prinzipielle Aufbau der Messanordnung 21 entspricht dem hinsichtlich der Messanordnung 11 im Zusammenhang mit Figur 1 erläuterten Aufbau, so dass nachfolgend im Wesentlichen auf die Unterscheidungsmerkmale eingegangen wird.

Auch die Messanordnung 21 weist Messeingänge 22a-c auf, über die der Messanordnung 21 Signale elektrischer Wechselgrößen zugeführt werden können. Den Messeingängen 22a-c ist eine Abtasteinrichtung 23 nachgeordnet, die ausgangsseitig mit einer Taktnachführeinrichtung 24 verbunden ist.

Im Unterschied zur Messanordnung 11 gemäß Figur 1 weist die Abtasteinrichtung 23 mehrere Abtastkomponenten auf, von denen in Figur 2 beispielhaft die Abtastkomponenten 23a und 23b gezeigt sind. Hierbei sind die Messeingänge 22a und 22b der ersten Abtastkomponente 23a zugeordnet, während der Messeingang 22b der zweiten Abtastkomponente 23b zugeordnet ist. Entsprechend der Anzahl der Abtastkomponenten weist auch die Taktnachführeinrichtung 24 mehrere Taktnachführkomponenten auf, von denen in Figur 2 beispielhaft die Taktnachführkomponenten 24a und 24b gezeigt sind.

Die Zuordnung der Messeingänge 22a-c zu den einzelnen Abtastkomponenten 23a, 23b der Abtasteinrichtung 23 erfolgt in der Weise, dass jeweils solche Messeingänge, die mit Signalen beaufschlagt werden, deren Frequenzen übereinstimmen, in einer sogenannten "Nachführgruppe" zusammengefasst werden. Die Messeingänge einer Nachführgruppe werden jeweils einer Abtastkomponente 23a, 23b der Abtasteinrichtung 23 zugeordnet. Vorliegend weisen die Signale an den Messeingängen 22a und 22b dieselbe Frequenz auf und werden daher in einer Nachführgruppe zusammengefasst, die der Abtastkomponente 23a zugeordnet ist. Das Signal an Messeingang 23c kann eine davon verschiedene Frequenz aufweisen und gehört daher zu einer zweiten Nachführgruppe, die der Abtastkomponente 23b zugeordnet ist.

Bei der Zuordnung der Messeingänge zu den Nachführgruppen werden die Messstellen betrachtet, an denen die jeweiligen Signale erfasst werden, die der Messanordnung zugeführt werden. Solche Messstellen, die dauerhaft miteinander galvanisch verbunden sind, werden derselben Nachführgruppe zugeordnet, da angenommen wird, dass die dort jeweils erfassten Signale hinsichtlich ihrer Frequenzen übereinstimmen. Messstellen, die galvanisch voneinander getrennt sind oder - zum Beispiel durch Schalteinrichtungen - voneinander galvanisch trennbar sind, werden unterschiedlichen Nachführgruppen zugeordnet. Die Zuordnung kann hierbei beispielsweise durch benutzerseitige Einstellung bei der Parametrierung des Gerätes 20 stattfinden. Alternativ kann auch eine automatische Zuordnung stattfinden. Diese kann im Falle eines von dem Gerät automatisierten elektrischen Energieversorgungsnetzes anhand der Topologie und/oder des Zustands der Schalteinrichtungen im Energieversorgungsnetz erfolgen. Die Zuordnung kann statisch festgelegt oder - insbesondere bei automatischer Zuordnung - dynamisch vorgenommen werden.

Pro Nachführgruppe weist die Taktnachführeinrichtung 24 eine Taktnachführkomponente 24a, 24b auf. Dazu wird mit jeder Taktnachführkomponente 24a, 24b die Frequenz der Signale der jeweiligen Nachführgruppe bestimmt. Vorzugsweise findet die Frequenzbestimmung jeweils nur bezüglich eines Signals der jeweiligen Nachführgruppe statt, um den Aufwand zur Frequenzmessung zu minimieren. Anhand der bestimmten Frequenz wird von der Taktnachführeinrichtung 24 ein jeweiliges Taktsignal erzeugt und der Abtasteinrichtung 23 zugeführt.

Konkret wird im Fall der Figur 2 mit der Taktnachführkomponente 24a die Frequenz des am Messeingang 22b anliegenden Signals bestimmt. Da die Messeingänge 22a und 22b derselben Nachführgruppe zugeordnet sind, kann die bestimmte Frequenz auch für das am Messeingang 22a anliegende Signal verwendet werden. Anhand der bestimmten Frequenz ermittelt die Taktnachführkomponente 24a ein Taktsignal Tₐ, das der Abtastkomponente 23a zugeführt wird. Somit kann eine Abtastung der an den Messeingängen 22a und 22b anliegenden Signale mit einem durch das Taktsignal Tₐ auf die Signalfrequenz angepassten Abtasttakt vorgenommen werden. In entsprechender Weise wird mit der Taktnachführkomponente 24b die Frequenz des am Messeingang 22c anliegenden Signals bestimmt. Anhand der bestimmten Frequenz ermittelt die Taktnachführkomponente 24b ein Taktsignal T_{b}, das der Abtastkomponente 23b zugeführt wird. Somit kann eine Abtastung des am Messeingang 22c anliegenden Signals mit einem durch das Taktsignal T_{b} auf die Signalfrequenz angepassten Abtasttakt vorgenommen werden.

Die konkrete Funktionsweise der Anpassung des Abtasttaktes ist für die Ausführung der Messanordnung nicht relevant. Sie kann beispielsweise derjenigen entsprechen, die in der eingangs genannten Patentschrift DE 102 03 683 C1 erläutert worden ist.

Die mit dem jeweils angepassten Abtasttakt abgetasteten Signale werden zur weiteren Auswertung Beobachtungs-, Schutz- und/oder Überwachungsfunktionen 25a und 25b zugeführt, die von einer Steuereinrichtung des Gerätes 20 ausgeführt werden. Dabei muss darauf geachtet werden, dass einer Beobachtungs-, Schutz- und/oder Überwachungsfunktion jeweils nur solche Signale zugeführt werden, die derselben Nachführgruppe angehören.

Die Anzahl und Aufteilung der Nachführgruppen ist jeweils an die Anlage anzupassen, an der mit dem Gerät die Signale erfasst werden. Entsprechend der Anzahl der Nachführgruppen ist die Zahl der Abtastkomponenten und der Taktnachführkomponenten zu bemessen.

Die Abtastkomponenten und Taktnachführkomponenten können als Hardware oder als Software ausgebildet sein. Im Falle einer Ausbildung als Software können beispielsweise entsprechende Instanzen digitaler Filter und anderer Funktionsmodule angelegt werden. Insbesondere bei einer softwarebasierten Ausführung lässt sich eine dynamische Anpassung der Nachführgruppen sehr einfach realisieren.

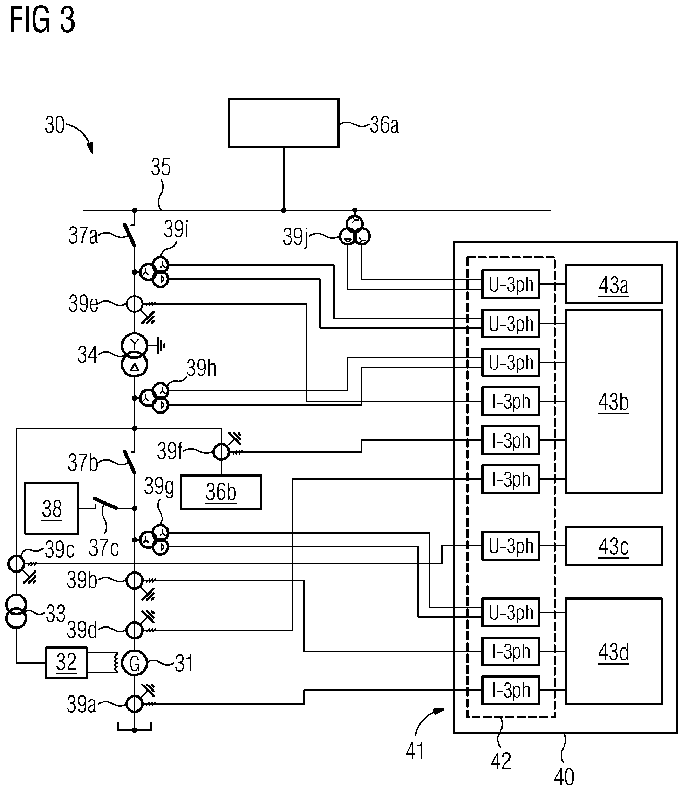

In Figuren 3-5 ist ein detailliertes Beispiel eines Energieversorgungsnetzes 30 mit einem Kraftwerksblock gezeigt, das mit einem Schutzgerät 40 überwacht wird.

Dabei weist das Energieversorgungsnetz 30 einen Generator 31 auf, der über eine Erregerspule 32, die von einem Erregertransformator 33 gespeist wird, angefahren werden kann. Der Kraftwerksblock ist über einen Blocktransformator 34 mit einer Sammelschiene 35 verbunden, die mit dem übrigen - in Figuren 3-5 nicht im Einzelnen gezeigten - Netz 36a verbunden ist. Mit dem Bezugszeichen 36b ist ein Eigenbedarfsnetz des Kraftwerks bezeichnet.

Der Kraftwerksblock kann von der Sammelschiene über einen Hochspannungs-Leistungsschalter 37a abgetrennt werden. Der Generator 31 selbst kann von dem Blocktransformator 34 über einen Generator-Leistungsschalter 37b abgetrennt werden.

Ein Anfahrumrichter 38 kann zudem über einen Umrichter-Leistungsschalter 37c mit dem Kraftwerksblock verbunden werden.

Das Energieversorgungsnetz 30 weist eine Vielzahl von Messstellen auf, an denen mit Sensoren elektrische Wechselgrößen erfasst werden. Konkret sind ein erster Stromwandler 39a zur Erfassung eines dreiphasigen Stromsignals ("I-3ph"), ein zweiter Stromwandler 39b zur Erfassung eines dreiphasigen Stromsignals, ein dritter Stromwandler 39c zur Erfassung einer dreiphasigen Stromsignals, ein vierter Stromwandler 39d zur Erfassung eines dreiphasigen Stromsignals, ein fünfter Stromwandler 39e zur Erfassung eines dreiphasigen Stromsignals und ein sechster Stromwandler 39f zur Erfassung eines dreiphasigen Stromsignals vorgesehen. Außerdem sind ein erster Spannungswandler 39g zur Erfassung eines dreiphasigen Spannungssignals ("U-3ph"), ein zweiter Spannungswandler 39h zur Erfassung eines dreiphasigen Spannungssignals, ein dritter Spannungswandler 39i zur Erfassung eines dreiphasigen Spannungssignals und ein vierter Spannungswandler 39j zur Erfassung eines dreiphasigen Spannungssignals vorgesehen.

Die Signale werden entsprechenden Messeingängen 41 des Schutzgerätes 40 zugeführt. Das Schutzgerät 40 umfasst eine entsprechend den Erläuterungen zu Figur 2 ausgebildete Messanordnung 42 mit Abtasttaktnachführung, die der Übersichtlichkeit halber nicht im Detail dargestellt ist. Außerdem umfasst das Schutzgerät 40 Beobachtungs-, Schutz- und/oder Überwachungsfunktionen 43a-d, die zur Analyse der an den Messeingängen 41 des Schutzgeräts 40 anliegenden Signale dienen. Beispielsweise kann es sich bei der Funktion 43a um einen Spannungs- und Frequenzschutz, bei der Funktion 43b um einen Transformatorschutz und einen Leitungsschutz (Hochspannungsseite), bei der Funktion 43c um einen Überstrom- und einen Überlastschutz und bei der Funktion 43d um einen Generatorschutz handeln. Andere Funktionen sind selbstverständlich ebenso möglich.

Durch die im Energieversorgungsnetz 30 vorhandenen Leistungsschalter 37a-c sind Betriebszustände möglich, bei denen einzelne Messstellen galvanisch voneinander getrennt sind. Aus diesem Grunde ergibt sich die Notwendigkeit der Einteilung der Messeingänge in Nachführgruppen. Im konkreten Beispiel sind aufgrund der Topologie und der möglichen Trennungen drei Nachführgruppen erforderlich. Die Messeingänge 41 sind daher unterschiedlichen Nachführgruppen zugeordnet. So ist der dem vierten Spannungswandler 39j zugeordnete Messeingang allein einer ersten Nachführgruppe zugeordnet. Einer zweiten Nachführgruppe sind diejenigen Messeingänge zugeordnet, die dem zweiten Spannungswandler 39h und dem dritten Spannungswandler 39i sowie dem dritten Stromwandler 39c, dem vierten Stromwandler 39d, dem fünften Stromwandler 39e und dem sechsten Stromwandler 39f zugeordnet sind. Einer dritten Nachführgruppe sind schließlich diejenigen Messeingänge zugeordnet, die dem ersten Spannungswandler 39g sowie dem ersten Stromwandler 39a und dem zweiten Stromwandler 39b zugeordnet sind.

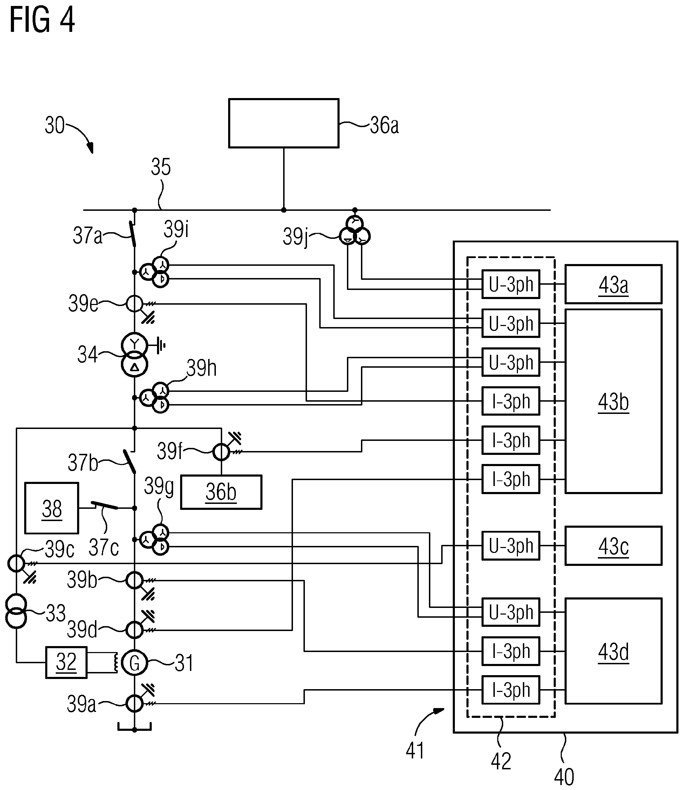

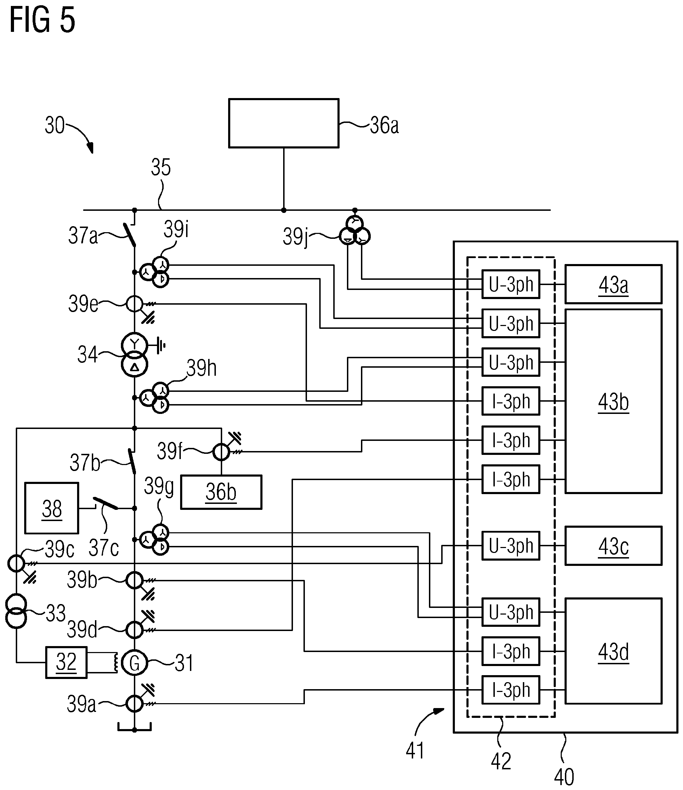

Beim Anfahren, Abfahren und nach Schutzauslösungen des in Figur 3 beispielhaft genannten Kraftwerksblockes sind unterschiedliche Schaltzustände möglich. In den Figuren 4 und 5 sollen verschiedene Schaltzustände erläutert werden, die zu unterschiedlichen Frequenzen führen und damit die Notwendigkeit der Gruppenbildung verdeutlichen.

Hierzu zeigt Figur 4 ein erstes Szenario, in dem der Hochspannungs-Leistungsschalter 37a geschlossen und der Generator-Leistungsschalter 37b offen ist. Das Netz 36a speist über den Blocktransformator 34 den Eigenbedarf des Kraftwerksnetzes 36b. Damit haben Signale der oben erläuterten Nachführgruppen 1 und 2 übereinstimmende Frequenzen. Der Umrichter-Leistungsschalter 37c ist geschlossen und über den Anfahrumrichter 38 wird der Generator 31 mit angeschlossener Gasturbine von 0Hz beginnend hochgefahren. Damit ist die Frequenz der zur Nachführgruppe 3 gehörenden Signale deutlich unterschiedlich zu derjenigen der Signale der Nachführgruppen 1 und 2. Die Erregung wird über den Erregertransformator 33 gespeist, welcher an die Unterspannungsseite des Blocktransformators 34 angeschlossen ist. Der dritte Stromwandler 39c ist somit der Nachführgruppe 2 zuzuordnen und hat eine direkte Verbindung zu den erforderlichen Schutzfunktionen (Überstrom, Überlast). Einen Spezialfall stellt der vierte Stromwandler 39d dar. Obwohl er sich unterhalb des Generator-Leistungsschalters 37b befindet, ist er der Nachführgruppe 2 zuzuordnen. Bei offenem Generator-Leistungsschalters 37b und Speisung über den Anfahrumrichter 38 wird ein Strom eingespeist, der nicht dem im Transformatorschutz verwendeten Knotenpunktsatz (Transformatordifferentialschutz) entspricht. Diese Messstelle ist für den Transformatorschutz "frei zu schalten", also aus der Messung herauszunehmen. Alternativ ist der Transformatorschutz unempfindlicher einzustellen.

Bei dem in Figur 5 dargestellten Szenario ist der Kraftwerksblock zunächst mit dem Netz 36a verbunden. Durch einen nicht rechtzeitig abgeschalteten Netzkurzschluss kommt es zur Schutzauslösung (z.B. über den Kraftwerksentkupplungsschutz). Der Nahkurzschluss bedeutet eine Wirkentlastung des Generators 31 und damit eine Beschleunigung des Läufers. Durch die Schutzauslösung wird der Hochspannungs-Leistungsschalter 37a geöffnet. Nach Öffnung des Hochspannungs-Leistungsschalters 37a führt die Läuferbeschleunigung zu einer höheren Frequenz des Kraftwerksblockes. Damit sind Frequenz des Netzes 36a und des Kraftwerksblockes unterschiedlich. Um die Messgrößen an der Sammelschiene 35 genau zu messen, ist der vierte Spannungswandler 39j einer eigenen Nachführgruppe, der Nachführgruppe 1 zuzuordnen. Nachführgruppen 2 und 3 haben in diesem Beispiel die gleiche Frequenz. Die Drehzahlregelung des Kraftwerksblockes führt dessen Frequenz wieder an die Netzfrequenz heran und der Kraftwerksblock kann rücksynchronisiert werden.

Obwohl die Erfindung voranstehend an Ausführungsbeispielen beschrieben worden ist, die ein lokales Schutzgerät zum Gegenstand hatten, ist es im Rahmen der Erfindung auch möglich, dass die Messanordnung Bestandteil einer zentralen Datenverarbeitungseinrichtung ist. Damit lassen sich Anwendungen wie ein zentraler Anlagenschutz, Prozessbusapplikationen oder cloudbasierte Services realisieren.

Grundlegend ist die Verwendung einer eigenen Taktnachführung für jeweils solche Signale, die unterschiedliche Frequenzen aufweisen können. Damit kann eine gleichzeitige Taktnachführung für alle Signale erreicht werden. Dies kann z.B. durch Bildung von Nachführgruppen wie oben erläutert erfolgen.

Vorteile der beschriebenen Messanordnung sind unter Anderem geringere Hardwarekosten, denn ein einzelnes Gerät kann für komplexere Anlagenausführungen genutzt werden. Durch die Bildung von Nachführgruppen und die Zuordnung der Messeingänge zu diesen Nachführgruppen wird auch bei galvanisch getrennten Anlagenteilen eine hohe Messgenauigkeit erreicht und es werden Fehlfunktionen vermieden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Messanordnung (21) mit
- zumindest zwei Messeingängen (22a-c) zum Erfassen von Signalen elektrischer Wechselgrößen;
- einer den Messeingängen (22a-c) nachgeordneten Abtasteinrichtung (23), mit der eine Abtastung der Signale unter Bildung digitaler Abtastwerte vorgenommen wird; und
- einer Taktnachführeinrichtung (24), die eine Anpassung eines von der Abtasteinrichtung (23) für die Abtastung verwendeten Abtasttaktes hinsichtlich der Frequenz des abzutastenden Signals vornimmt; wobei
- die Abtasteinrichtung (23) dazu eingerichtet ist, zumindest zwei der Signale mit jeweils einem eigenen Abtasttakt abzutasten, wobei die Taktnachführeinrichtung (24) dazu eingerichtet ist, gleichzeitig für jedes dieser zumindest zwei Signale eine Anpassung des Abtasttaktes hinsichtlich der Frequenz des abzutastenden Signals vorzunehmen,
wobei
- die Messanordnung (21) Teil eines Gerätes (20) zum Beobachten, Überwachen und/oder Schützen eines elektrischen Energieversorgungsnetzes ist; **dadurch gekennzeichnet dass**
- die Messeingänge (22a-c) in verschiedene Nachführgruppen aufgeteilt sind, wobei jeweils Messeingänge (22a-c) solcher Signale, deren Frequenz aufgrund der Gegebenheiten des Energieversorgungsnetzes übereinstimmen, in derselben Nachführgruppe zusammengefasst sind; und
- die Taktnachführeinrichtung (24) dazu eingerichtet ist, für jede Nachführgruppe eine Anpassung des Abtasttaktes vorzunehmen.

2. Messanordnung (21) nach Anspruch 1,
**dadurch gekennzeichnet, dass**
- solche Messeingänge (22a-c) unterschiedlichen Nachführgruppen zugeordnet werden, die Signalen zugeordnet sind, die an galvanisch voneinander abtrennbaren Messstellen des Energieversorgungsnetzes erfasst werden.

3. Messanordnung (21) nach Anspruch 1 oder 2,
**dadurch gekennzeichnet, dass**
- die Nachführgruppen durch benutzerseitige Einstellung der Messanordnung (21) vorgebbar sind.

4. Messanordnung (21) nach Anspruch 1 oder 2,
**dadurch gekennzeichnet, dass**
- die Nachführgruppen von der Messanordnung (21) automatisch anhand der Topologie des Energieversorgungsnetzes und/oder des Zustands von Schalteinrichtungen des Energieversorgungsnetzes gebildet werden.

5. Messanordnung (21) nach einem der vorangehenden Ansprüche, **dadurch gekennzeichnet, dass**
- die Taktnachführeinrichtung (24) dazu eingerichtet ist, die Frequenz jeweils eines Signals jeder Nachführgruppe zu bestimmen und anhand der bestimmten Frequenz die Anpassung des Abtasttaktes für alle zu der jeweiligen Nachführgruppe gehörenden Messeingänge (22a-c) vorzunehmen.

6. Messanordnung (21) nach einem der vorangehenden Ansprüche, **dadurch gekennzeichnet, dass**
- die Messanordnung (21) eine Steuereinrichtung umfasst, die mindestens zwei Beobachtungs-, Schutz- und/oder Überwachungsfunktionen (25a-b) ausführt; und
- jeder Beobachtungs-, Schutz- und/oder Überwachungsfunktion (25a-b) ausschließlich solche Abtastwerte zugeführt werden, die durch Abtastung von Signalen an Messeingängen (22a-c) gewonnen worden sind, die derselben Nachführgruppe zugeordnet sind.

7. Messanordnung (21) nach einem der Ansprüche 2 bis 6, **dadurch gekennzeichnet, dass**
- das Gerät (20) ein lokales Schutzgerät oder eine zentrale Datenverarbeitungsanlage ist.

8. Verfahren zum Messen elektrischer Signale, wobei
- mit zumindest zwei Messeingängen (22a-c) einer Messanordnung (21) Signale elektrischer Wechselgrößen erfasst werden;
- mit einer den Messeingängen (22a-c) nachgeordneten Abtasteinrichtung (23) der Messanordnung (21) eine Abtastung der Signale unter Bildung digitaler Abtastwerte vorgenommen wird; und
- mit einer Taktnachführeinrichtung (24) der Messanordnung (21) eine Anpassung eines von der Abtasteinrichtung (23) für die Abtastung verwendeten Abtasttaktes hinsichtlich der Frequenz des abzutastenden Signals vorgenommen wird; wobei
- mit der Abtasteinrichtung (23) zumindest zwei der Signale mit jeweils einem eigenen Abtasttakt abgetastet werden, indem die Taktnachführeinrichtung (24) gleichzeitig für jedes dieser zumindest zwei Signale eine Anpassung des Abtasttaktes hinsichtlich der Frequenz des abzutastenden Signals vornimmt, wobei
- die Messanordnung (21) Teil eines Gerätes (20) zum Beobachten, Überwachen und/oder Schützen eines elektrischen Energieversorgungsnetzes ist, **dadurch gekennzeichnet, dass**
- die Messeingänge (22a-c) in verschiedene Nachführgruppen aufgeteilt sind, wobei jeweils Messeingänge (22a-c) solcher Signale, deren Frequenz aufgrund der Gegebenheiten des Energieversorgungsnetzes übereinstimmen, in derselben Nachführgruppe zusammengefasst sind; und
- die Taktnachführeinrichtung (24) für jede Nachführgruppe eine Anpassung des Abtasttaktes vornimmt.

## Claims

1. Measuring arrangement (21) with
- at least two measurement inputs (22a-c) for the capture of signals of alternating electrical magnitudes;
- a sampling apparatus (23) that is arranged following the measurement inputs (22a-c) with which a sampling of the signals is performed while forming digital sample values; and
- a clock tracking apparatus (24) that performs an adaptation of a sampling clock used by the sampling apparatus (23) for the sampling in the light of the frequency of the signal to be sampled; wherein
- the sampling apparatus (23) is configured to sample at least two of the signals, each with its own sampling clock, wherein the clock tracking apparatus (24) is configured to perform an adaptation of the sampling clock in the light of the frequency of the signal to be sampled simultaneously for each of these at least two signals, wherein
- the measuring arrangement (21) is part of a device (20) for the observation, monitoring and/or protection of an electrical energy supply network; **characterized in that**
- the measurement inputs (22a-c) are divided into different tracking groups, wherein respective measurement inputs (22a-c) of such signals whose frequencies, as a result of the particular features of the energy supply network, match are grouped into the same tracking group; and
- the clock tracking apparatus (24) is configured to perform an adaptation of the sampling clock for each tracking group.

2. Measuring arrangement (21) according to Claim 1, **characterized in that**
- such measurement inputs (22a-c) that are assigned to signals that are acquired at measurement points of the energy supply network that can be galvanically separated from one another are assigned to different tracking groups.

3. Measuring arrangement (21) according to Claim 1 or 2, **characterized in that**
- the tracking groups can be specified by an adjustment of the measuring arrangement (21) on the part of the user.

4. Measuring arrangement (21) according to Claim 1 or 2, **characterized in that**
- the tracking groups are formed automatically by the measuring arrangement (21) on the basis of the topology of the energy supply network and/or of the state of switching apparatuses of the energy supply network.

5. Measuring arrangement (21) according to one of the preceding claims,
**characterized in that**
- the clock tracking apparatus (24) is configured to determine in each case the frequency of one signal of each tracking group, and to perform the adaptation of the sampling clock for all the measurement inputs (22a-c) belonging to the respective tracking group on the basis of the frequency determined.

6. Measuring arrangement (21) according to one of the preceding claims,
**characterized in that**
- the measuring arrangement (21) comprises a control apparatus that carries out at least two observation, protection and/or monitoring functions (25a-b); and
- exclusively such sample values as have been obtained by sampling signals at measurement inputs (22a-c) that are assigned to the same tracking group are supplied to each observation, protection and/or monitoring function (25a-b).

7. Measuring arrangement (21) according to one of Claims 2 to 6,
**characterized in that**
- the device (20) is a local protection device or a central data processing installation.

8. Method for measuring electrical signals, wherein
- signals of alternating electrical magnitudes are acquired with at least two measurement inputs (22a-c) of a measuring arrangement (21);
- a sampling of the signals is performed while forming digital sample values with a sampling apparatus (23) of the measuring arrangement (21) that is arranged following the measurement inputs (22a-c); and
- an adaptation of a sampling clock used by the sampling apparatus (23) for the sampling is performed by a clock tracking apparatus (24) of the measuring arrangement (21) in the light of the frequency of the signal to be sampled; wherein
- at least two of the signals are sampled with the sampling apparatus (23) each with its own sampling clock, in that the clock tracking apparatus (24) performs an adaptation of the sampling clock in the light of the frequency of the signal to be sampled simultaneously for each of these at least two signals, wherein
- the measuring arrangement (21) is part of a device (20) for the observation, monitoring and/or protection of an electrical energy supply network, **characterized in that**
- the measurement inputs (22a-c) are divided into different tracking groups, wherein respective measurement inputs (22a-c) of such signals whose frequencies, as a result of the particular features of the energy supply network, match are grouped into the same tracking group; and
- the clock tracking apparatus (24) performs an adaptation of the sampling clock for each tracking group.

## Revendications

1. Montage (21) de mesure comprenant
- au moins deux entrées (22a-c) de mesure pour la détection de signaux de grandeurs alternatives électriques ;
- un dispositif (23) d'échantillonnage, qui est monté en aval des entrées (22a-c) de mesure et par lequel un échantillonnage des signaux est effectué avec formation de valeurs d'échantillonnage numériques ; et
- un dispositif (24) de suivi de cadence, qui effectue une adaptation d'une cadence d'échantillonnage utilisée pour l'échantillonnage par le dispositif (23) d'échantillonnage en ce qui concerne la fréquence du signal à échantillonner ; dans lequel
- le dispositif (23) d'échantillonnage est conçu pour échantillonner au moins deux des signaux à respectivement sa propre cadence d'échantillonnage, dans lequel le dispositif (24) de suivi de cadence est conçu pour effectuer, en même temps pour chacun des au moins deux signaux, une adaptation de la cadence d'échantillonnage en ce qui concerne la fréquence du signal à échantillonner,
dans lequel
- le montage (21) de mesure fait partie d'un appareil (20) d'observation, de contrôle et/ou de protection d'un réseau d'alimentation en énergie électrique ; **caractérisé en ce que**
- les entrées (22a-c) de mesure sont réparties en divers groupes de suivi, dans lequel respectivement des entrées (22a-c) de mesure des signaux, dont les fréquences coïncident, en raison des circonstances dans le réseau d'alimentation en énergie, sont rassemblées en le même groupe de suivi; et
- le dispositif (24) de suivi de cadence est conçu pour effectuer, pour chaque groupe de suivi, une adaptation de la cadence d'échantillonnage.

2. Montage (21) de mesure suivant la revendication 1, **caractérisé en ce que**
- sont associées aux groupes de suivi différents les entrées (22a-c) de mesure, qui sont associées à des signaux, qui sont détectés en des points, pouvant être séparés les uns des autres galvaniquement, du réseau d'alimentation en énergie.

3. Montage (21) de mesure suivant la revendication 1 ou 2, **caractérisé en ce que**
- les groupes de suivi peuvent être prescrits par réglage par un utilisateur du montage (21) de mesure.

4. Montage (21) de mesure suivant la revendication 1 ou 2, **caractérisé en ce que**
- les groupes de suivi sont formés par le montage (21) de mesures automatiquement, à l'aide de la topologie du réseau d'alimentation en énergie et/ou de l'état de dispositifs de coupure du réseau d'alimentation en énergie.

5. Montage (21) de mesure suivant l'une des revendications précédentes,
**caractérisé en ce que**
- le dispositif (24) de suivi de cadence est conçu pour déterminer la fréquence respectivement d'un signal de chaque groupe de suivi et pour effectuer, à l'aide de la fréquence déterminée l'adaptation de la cadence d'échantillonnage, pour toutes les entrées (22a-c) de mesure appartenant au groupe de suivi respectif.

6. Montage (21) de mesure suivant l'une des revendications précédentes,
**caractérisé en ce que**
- le montage (21) de mesure comprend un dispositif de commande, qui remplit au moins deux fonctions (25a-b) d'observation, de protection et/ou de contrôle ; et
- à chaque fonction (25a-b) d'observation de protection et/ou de contrôle sont envoyées exclusivement des valeurs d'échantillonnage, qui ont été obtenues par échantillonnage de signaux aux entrées (22a-c) de mesure, qui sont associées au même groupe de suivi.

7. Montage (21) de mesure suivant l'une des revendications 2 à 6,
**caractérisé en ce que**
- l'appareil (20) est un appareil de protection locale ou une installation centrale de traitement de données.

8. Procédé de mesure de signaux électriques, dans lequel
- par au moins deux entrées (22a-c) de mesure d'un montage (21) de mesure, on détecte des signaux de grandeurs alternatives électriques ;
- par un dispositif (23) d'échantillonnage, monté en aval des entrées (22a-c) de mesure, du montage (21) de mesure, on effectue un échantillonnage des signaux avec formation de valeurs d'échantillonnage numériques ; et
- par un dispositif (24) de suivi de cadence du montage (21) de mesure, on effectue une adaptation en ce qui concerne la fréquence du signal à échantillonner d'une cadence d'échantillonnage utilisée pour l'échantillonnage par le dispositif (23) d'échantillonnage ; dans lequel
- par le dispositif (23) d'échantillonnage, on échantillonne au moins deux des signaux avec respectivement sa propre cadence d'échantillonnage, par le fait que le dispositif (24) de suivi de cadence effectue, en même temps pour chacun de ces au moins deux signaux, une adaptation de la cadence d'échantillonnage en ce qui concerne la fréquence du signal à échantillonner,
dans lequel
- le montage (21) de mesure fait partie d'un appareil (20) d'observation, de contrôle et/ou de protection d'un réseau d'alimentation en énergie électrique, **caractérisé en ce que**
- les entrées (22a-c) de mesure sont réparties en divers groupes de suivi, dans lequel des entrées (22a-c) de mesure des signaux, dont les fréquences coïncident en raison des circonstances dans le réseau d'alimentation en énergie, sont rassemblées en le même groupe de suivi ; et
- le dispositif (24) de suivi de cadence effectue pour chaque groupe de suivi une adaptation de la cadence d'échantillonnage.
